# FASCICULE DE BREVET EUROPEEN

(11) **EP 2 592 426 B1**
(45) Date de publication et mention de la délivrance du brevet: **25.09.2024**
(21) Numéro de dépôt: 12191911.2
(22) Date de dépôt: 09.11.2012
(51) Int. Cl.: G01R 15/18, H01F 38/30, G01R 1/22

(54) **Capteur pour la mesure d'un courant dans un câble électrique**
Messfühler zur Strommessung in einem elektrischen Kabel
Sensor for measuring a current in an electric cable

(30) Priorité: 10.11.2011 FR 1160249
(43) Date de publication de la demande: 15.05.2013
(73) Titulaire: Schneider Electric Industries SAS, 92500 Rueil-Malmaison (FR)
(72) Inventeur: Waterlot, Frédéric, 73190 ST BALDOPH (FR); Contini, Erick, 38240 MEYLAN (FR); Moreux, Alain, 21000 DIJON (FR); Clemence, Michel, 73000 CHAMBERY (FR)
(74) Mandataire: Lavoix

(56) Documents cités:
- EP-A1- 0 018 921
- EP-A1- 2 511 712
- FR-A- 991 779
- FR-A1- 2 646 714
- FR-A1- 2 717 582
- GB-A- 987 310
- US-A- 3 652 935
- US-A1- 2008 129 314
- US-A1- 2011 068 773

## Description

La présente invention est relative à un capteur selon le préambule de la revendication 1.

Il est connu de mesurer des courants industriels, notamment à basse ou moyenne fréquence, en disposant autour du câble électrique concerné un capteur du type précité. Le câble électrique agit comme le primaire d'un transformateur et le circuit électrique du capteur agit comme le secondaire du transformateur. En mesurant des caractéristiques de la tension induite dans le secondaire du transformateur, il est possible de déterminer l'intensité du courant circulant dans le primaire du transformateur, c'est-à-dire dans le câble électrique.

Ainsi, le document EP-A-0 999 565 décrit un dispositif de mesure d'un courant électrique. Ce dispositif comprend un transformateur pourvu d'un circuit magnétique en forme de tore ouvrant susceptible de se refermer sur un câble dans lequel circule le courant à mesurer. Ce dispositif présente l'inconvénient que la fermeture du tore après passage autour du câble électrique est réalisée manuellement. Quand l'accès est étroit, la fermeture est malaisée et peut poser des problèmes de sécurité.

Le document FR-A-1 478 330 décrit un procédé de mesure de courants industriels jusqu'à plusieurs centaines de milliers de Hertz utilisant le champ magnétique du courant à mesurer. Il comprend un bobinage à une seule couche à faible pas, de section droite constante, pour lequel le conducteur de retour revient directement vers l'autre extrémité du bobinage suivant son axe, ledit bobinage formant une boucle fermée qui entoure le câble électrique dont on veut mesurer l'intensité. Un tel circuit est appelé tore de Rogowski. Celui-ci est relié à un circuit intégrateur RC, lui-même connecté à un appareil de mesure. Le procédé décrit nécessite cependant une intervention manuelle au niveau du bobinage pour fermer le tore. Ceci n'est pas aisé parmi une multitude de câbles électriques et peut poser des problèmes de sécurité pour l'opérateur.

Le document US-A-7 253 603 décrit un dispositif similaire. Le problème d'avoir à fermer manuellement le tore est résolu en mettant en oeuvre un « tore » restant ouvert en permanence. Ceci présente l'inconvénient que le circuit électrique est alors plus sensible aux champs électriques externes, qui peuvent parasiter la mesure.

Le document GB 987 310 A (GEN ELECTRIC CO LTD), 24 mars 1965, décrit un capteur conforme au préambule de la revendication 1.

Un but de l'invention est de fournir un capteur pour la mesure d'un courant dans un câble électrique dont la mise en oeuvre soit facilitée et sécurisée et qui fournisse une mesure précise du courant.

A cet effet, l'invention a pour objet un capteur selon la revendication 1.

Un élément, comme le câble électrique, est dit « à l'intérieur » de la boucle lorsque celle-ci entoure l'élément. Au contraire, un élément est dit « à l'extérieur » de la boucle lorsque celle-ci n'entoure pas l'élément.

Selon des modes particuliers de réalisation, le capteur peut comprendre une ou plusieurs des caractéristiques correspondant aux revendications 2 à 7.

L'invention concerne également un procédé de mesure d'un courant dans un câble électrique, le procédé mettant en oeuvre un capteur tel que décrit ci-dessus et comprenant les étapes suivantes :
- le câble électrique se situant à l'extérieur de la boucle et le support se trouvant dans la première position, on presse manuellement le support contre le câble électrique, le câble électrique étant en contact avec le support de part et d'autre de l'ouverture du support, de manière à déformer le support de la première position vers la seconde position et à faire entrer le câble électrique dans la boucle ; et
- le câble électrique se situant à l'intérieur de la boucle et le support ayant repris la première position, on mesure une ou plusieurs caractéristiques d'un courant induit dans le circuit électrique par le courant circulant dans le câble électrique, et on déduit une valeur du courant circulant dans le câble électrique à partir de la ou des caractéristiques mesurées.

Selon un mode particulier de réalisation, le procédé peut comprendre en outre l'étape suivante : le câble électrique se situant à l'intérieur de la boucle et le support se trouvant dans la première position, on presse manuellement le support contre le câble électrique, le câble électrique étant en contact avec le support de part et d'autre de l'ouverture du support, de manière à déformer le support de la première position vers la seconde position et à faire sortir le câble électrique de la boucle.

L'invention sera mieux comprise à la lecture de la description qui va suivre donnée uniquement à titre d'exemple et faite en se référant aux dessins annexés sur lesquels :
- la Figure 1 représente un capteur selon l'invention en vue de face ;
- la Figure 2 illustre un procédé selon l'invention mettant en oeuvre le capteur représenté sur la Figure 1 ;
- la Figure 3 représente un capteur en vue de face non couvert par le texte des revendications;
- la Figure 4 représente le capteur représenté sur la Figure 3 en vue de profil ;
- la Figure 5 illustre un procédé mettant en oeuvre le capteur représenté sur la Figure 3 ;
- les Figures 6, 7 et 8 représentent des tores de Rogowski constituant des modes de réalisation du circuit électrique du capteur représenté sur la Figure 1 ou du capteur représenté sur la Figure 3 ;
- la Figure 9 représente une variante du capteur représenté sur les Figures 3 à 5.

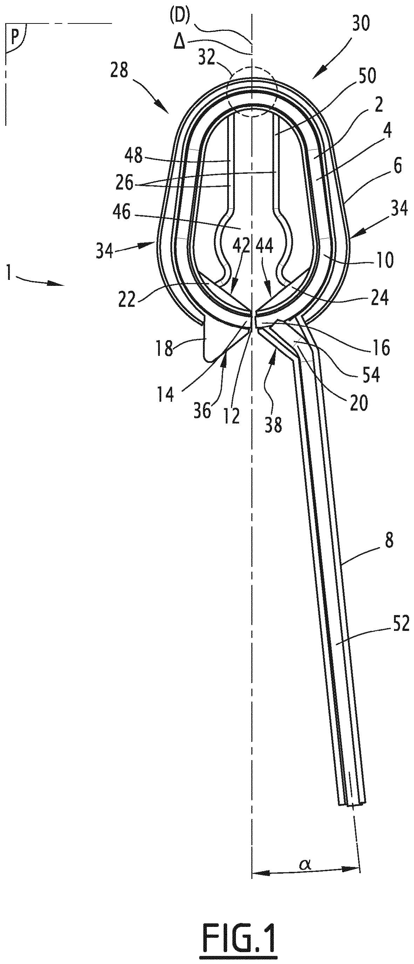

La Figure 1 représente un capteur 1 comprenant un circuit électrique 4 comportant un bobinage hélicoïdal, un support du circuit électrique 6 et un manche 8. Le support 6 et le manche 8 peuvent être monobloc, dans une seule matière ou deux matières différentes.

Le support 6 comprend une gouttière 10 en forme de boucle s'étendant sensiblement selon un plan P. La boucle est par exemple sensiblement symétrique selon un plan Δ orthogonal au plan P. Les plans P et Δ se coupent selon une direction D.

Le support 6 présente une ouverture 12 interrompant la boucle au niveau du plan Δ. Le support 6 comprend donc deux extrémités 14, 16 situées chacune de part et d'autre du plan Δ. Le support 6 comprend en outre deux guides externes 18, 20 situés de part et d'autre de l'ouverture 12, deux guides internes 22, 24 situés de part et d'autre de l'ouverture 12 et un élément de maintien en position 26 de câble électrique situé à l'intérieur de la boucle.

Le support 6 comprend deux branches 28, 30 partant d'une zone médiane 32 du support 6 située à l'opposé de l'ouverture 12 et s'étendant sensiblement dans le plan P selon deux formes courbes, symétriques l'une de l'autre par rapport au plan Δ, jusqu'aux extrémités 14, 16.

Avantageusement, la gouttière 10 est de forme générale oblongue, s'étendant selon la direction D. Selon un mode particulier, la gouttière 10 est sensiblement circulaire.

Le support 6 est déformable élastiquement entre une première position et une seconde position.

Dans la première position, le support 6 est au repos et les deux extrémités 14, 16 sont sensiblement en vis-à-vis. La boucle est alors quasiment fermée.

Avantageusement, les deux extrémités 14, 16 sont distantes de moins de 3 mm dans la première position. Par exemple, les deux extrémités 14, 16 sont en contact.

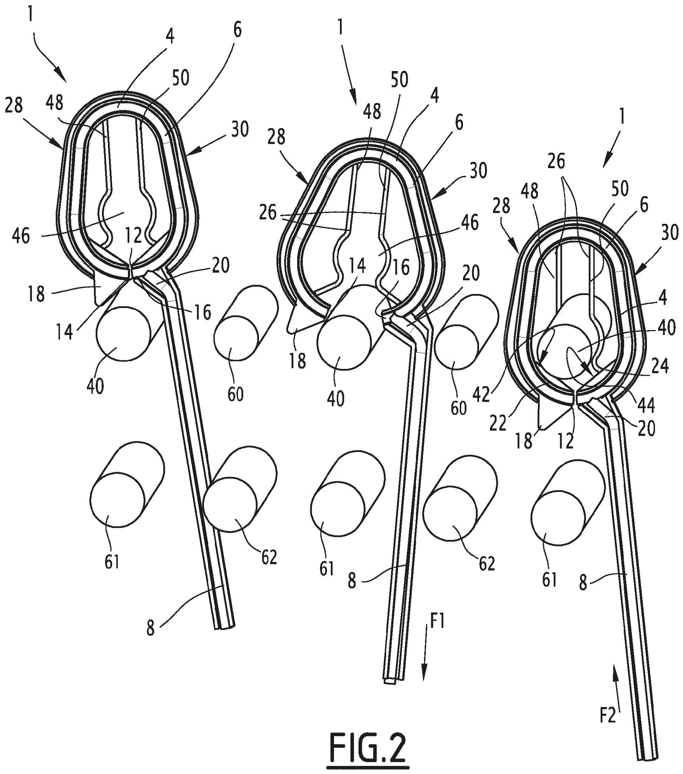

Sur la Figure 2, le support 6 du capteur 1 représenté à gauche se trouve dans la première position.

Sur la Figure 2, le support 6 du capteur 1 représenté au centre se trouve dans la seconde position. Dans la seconde position, les deux branches 28, 30 sont écartées l'une de l'autre par rapport à la première position.

Plus précisément, sur cet exemple, les deux extrémités 14, 16 du support sont éloignées l'une de l'autre sensiblement dans le plan P, selon une direction sensiblement orthogonale à la direction D.

La gouttière 10 est en matériau souple, par exemple en matière plastique.

La gouttière 10 comprend un logement adapté pour recevoir le circuit électrique. Dans l'exemple représenté sur la Figure 1, la gouttière 10 présente une section en U. Le U s'ouvre suivant une direction sensiblement orthogonale au plan P.

Selon un mode de réalisation particulier, la gouttière 10 peut être couverte, c'est-à-dire qu'elle peut comporter un cache fermant le « U ».

Les guides externes 18, 20 sont fixés de part et d'autre de l'ouverture 12 sur une paroi latérale externe 34 de la gouttière. Les guides externes 18, 20 s'étendent radialement à partir de la boucle dans le plan P.

Le premier guide externe 18 présente la forme d'une cale triangulaire en vue de face.

Le second guide externe 20 est avantageusement dans le prolongement du manche 8. Dit autrement, le manche 8 est alors fixé sur le second guide externe 20 et les deux sont en continuité de forme.

Les deux guides externes 18, 20 présentent chacun une surface de guidage 36, 38 destinée à être en contact avec le câble électrique lorsque l'opérateur presse le support sur le câble électrique 40 situé à l'extérieur de la boucle. Ces deux surfaces de guidage 36, 38 convergent vers l'ouverture 12 du support 6.

Chaque guide interne 22, 24 comprend une membrane oblique s'étendant sensiblement selon le plan P, à l'intérieur de la boucle formée par le support. Chaque membrane comporte un bord de guidage 42, 44 à l'intérieur de la boucle, allant d'une zone située au niveau d'une extrémité 14, 16 du support jusqu'à une zone intermédiaire du support. Les deux bords de guidage 42, 44 convergent vers l'ouverture 12 du support.

Les bords de guidage 42, 44 sont destinés à être en contact avec le câble électrique 40 lorsque l'opérateur presse le support 6 sur le câble électrique 40 situé à l'intérieur de la boucle.

L'élément de maintien en position 26 du câble électrique est situé à l'intérieur de la boucle formée par le support 6 et comprend un logement 46 pour recevoir le câble électrique 40 dans une position prédéfinie par rapport au circuit électrique 4. Plus précisément, l'élément de maintien en position 26 comprend deux parties tubulaires 48, 50 s'étendant sensiblement dans le plan P.

Les parties tubulaires 48, 50 sont fixées par l'une de leurs extrémités au support 6, au niveau de la partie médiane 32 et par l'autre de leurs extrémités sur l'un des guides internes 22, 24. En vue de face, chaque partie tubulaire 48, 50 comprend une section rectiligne située du côté de la zone médiane 32 du support et une section en S située du côté du guide interne 22, 24. Considérées ensemble, les deux parties tubulaires 48, 50 présentent dans le plan P une forme de lyre.

Le manche 8 est fixé au niveau de l'extrémité 16 du support 6 où se situent les bornes de raccordement électrique A et B.

Selon un mode de réalisation, le manche 8 s'étend sensiblement dans le plan P. Avantageusement, le manche s'étend selon la direction D ou selon une direction formant avec la direction D un angle α faible, par exemple inférieur ou égal à 30°, avantageusement choisi égal à environ 15°.

Le manche 8 est constitué d'une matière plus rigide que le support, de façon à ce que l'opérateur puisse déformer le support 6 en agissant sur le manche 8 de la manière décrite ci-dessous. En outre, le manche 8 est isolant électrique.

Par exemple, le manche 8 présente l'aspect d'une gouttière à section en U en continuité de matière avec la gouttière 10 du support.

Dans l'exemple représenté sur les figures 1 et 2, le manche 8 comprend une partie principale 52 sensiblement rectiligne destinée à être tenue par l'opérateur et une partie terminale 54 solidaire du support 6 et faisant un angle obtus avec la partie principale. La partie terminale 54 forme avantageusement le second guide externe 20.

Dans l'exemple représenté sur la Figure 1, le circuit électrique 4 se trouve dans le logement formé par la gouttière 10.

Le circuit électrique 4 se situe dans ou sur le support 6. Avantageusement, le circuit électrique 4 s'étend selon toute la longueur de la boucle, depuis l'extrémité 14 du support jusqu'à l'autre extrémité 16.

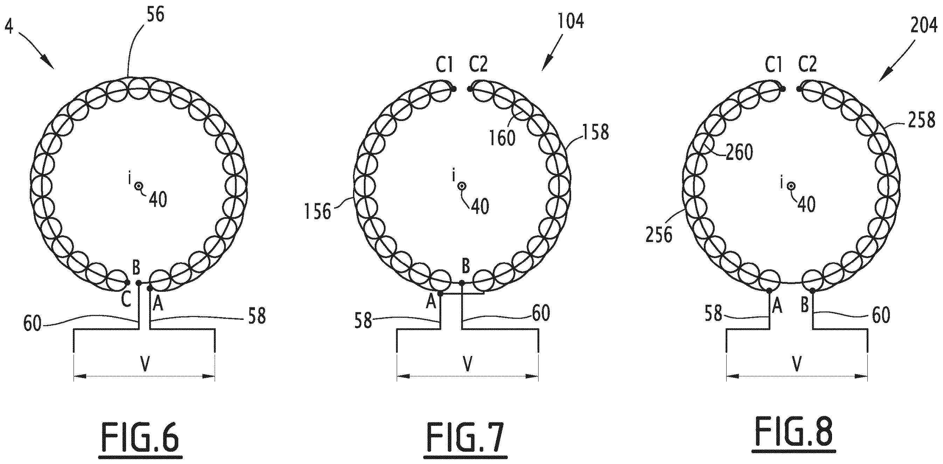

En référence à la Figure 6, le circuit électrique 4 comprend un fil conducteur 56 bobiné, un fil d'entrée 58 et un fil de sortie 60.

Les fils d'entrée 58 et de sortie 60 se situent dans le manche 8 et sont connectés respectivement à une borne d'entrée A et une borne de sortie B du fil conducteur 56 bobiné.

Avantageusement, le circuit électrique 4 constitue un tore de Rogowski tel que représenté schématiquement sur la Figure 6. La borne d'entrée A est située au niveau d'une extrémité 14 du support. A partir de cette borne d'entrée A, le fil 56 est bobiné régulièrement autour d'un noyau. Le bobinage est hélicoïdal et s'étend sur toute la boucle. Le bobinage s'arrête en un point C situé au niveau de l'autre extrémité 16 du support. A partir du point C, le fil 56 revient par l'intérieur du bobinage jusqu'à une borne de sortie B. Lorsque le support 6 est dans la première position, la première spire et la dernière spire du bobinage se font face de part et d'autre de l'ouverture 12 du support 6. Les bornes d'entrée A et de sortie B de l'enroulement se situent au niveau d'une même extrémité 14 du support 6.

Les fils d'entrée 58 et de sortie 60 du circuit électrique 4 situés dans le manche 8 sont connectés à un dispositif de mesure non représenté.

La Figure 2 illustre un procédé selon l'invention mettant en oeuvre le capteur 1 illustré sur la Figure 1.

Il s'agit par exemple de mesurer un courant i circulant dans le câble électrique 40 faisant partie d'une pluralité de câbles, par exemple des départs de câbles dans une armoire électrique ou un transformateur.

Les trois capteurs 1 représentés sur la Figure 2 illustrent, de gauche à droite, le même capteur 1 dans trois positions différentes qu'il occupe successivement lors d'une opération de mise en place du capteur sur le câble électrique 40.

Dans un premier temps, à l'aide du manche 8 tenu à la main, on déplace le capteur 1 de manière à amener le support 6 au voisinage du câble électrique 40 dont on veut mesurer le courant i. Ceci est illustré par le capteur 1 représenté à gauche sur la Figure 2. Le support 6 est alors dans la première position.

On met les deux guides externes 18, 20 du capteur 1 en contact avec le câble électrique 40, puis on exerce une force F₁ sur le manche 8 pour presser le support 6 contre le câble électrique 40. En réaction, le câble électrique 40 exerce des forces sur les guides externes 18, 20, ces forces tendant à écarter les branches 28, 30 du support 6 au niveau de l'ouverture 12, c'est-à-dire à provoquer une déformation élastique du support 6 vers la seconde position, illustrée par le capteur 1 représenté au centre sur la Figure 2.

Le câble électrique 40, alors situé entre les deux extrémités 14, 16 du support, entre dans la boucle formée par le support 6 et vient s'immobiliser dans le logement 46 de l'élément de maintien en position 26 en forme de lyre. Le support 6 revient alors spontanément à sa position de repos, c'est-à-dire la première position, illustrée par le capteur 1 représenté à droite sur la Figure 2.

Le support 6 et le circuit électrique 4 sont alors dans une position quasi-fermée autour du câble électrique 40. A l'aide du dispositif de mesure, on mesure la différence de potentiel V aux bornes A, B du circuit électrique 4 constituant un tore de Rogowski, cette différence de potentiel V étant induite par le courant électrique i circulant dans le câble électrique 40. Selon une méthode connue en soi, on en déduit le courant i circulant dans le câble électrique 40.

Une fois la mesure effectuée, on fait sortir le câble électrique 40 de la boucle en poussant sur le manche 8 (force F₂) de manière à presser le câble électrique 40 contre les guides internes 22, 24 du support 6.

Le câble électrique 40 sort du logement 46 de l'élément de maintien en position 26 pour venir en contact avec les surfaces de guidage 42, 44 des guides internes 22, 24. La réaction du câble électrique 40 sur les surfaces de guidage 42, 44 des guides internes 22, 24 écarte les extrémités 14, 16 du support 6. Le support 6 passe donc de la première position à la seconde position, illustrée par le capteur 1 représenté au centre sur la Figure 2.

Le câble électrique 40 franchit ensuite l'ouverture 12 du support 6 pour se retrouver à l'extérieur de la boucle. Le support 6 reprend sa première position illustrée par le capteur 1 représenté à gauche sur la Figure 2.

Grâce au capteur 1 selon l'invention, il est donc possible de faire entrer, puis de faire sortir un câble électrique 40 de la boucle formée par le support 6, sans intervention manuelle directe sur le support 6. La sécurité de l'opérateur est, de ce fait, améliorée. La mesure du courant i circulant dans le câble électrique 40 est précise car, lorsqu'elle est réalisée, la boucle formée par le support 6 est quasi-fermée.

Le manche 8 présente l'avantage de permettre à l'opérateur de garder sa main à une certaine distance du câble électrique 40, sur lequel porte la mesure, et de câbles électriques voisins 60, 61, 62, tout en offrant à l'opérateur une isolation électrique quand le manche 8 est fabriqué dans une matière isolante, en totalité ou en partie.

Grâce au manche 8, le câble électrique 40 peut être atteint par le capteur 1, même s'il est situé pour l'opérateur derrière plusieurs câbles électriques 60, 61, 62 parallèles au câble électrique 40. Le capteur 1 peut s'insinuer facilement entre les câbles électriques 40, 60, 61, 62 en orientant le plan P (plan du support 6) parallèlement à la direction des câbles électriques 40, 60, 61, 62. Puis, une fois que le support 6 se trouve derrière le câble électrique 40 par rapport à l'opérateur, un pivotement du capteur 1 d'environ 90° autour d'un axe matérialisé par le manche 8 met le capteur 1 dans une position adéquate pour faire entrer le câble électrique 40 dans la boucle formée par le support 6.

La fixation du manche 8 au niveau d'une des extrémités 16 du support 6, avec un angle α faible par rapport à la direction D, permet de faire entrer ou sortir le câble électrique 40 respectivement en tirant ou en poussant sur le manche 8, sans avoir à imprimer un mouvement de flexion au manche 8.

Lorsque le circuit électrique 4 constitue un tore de Rogowski, la mesure est a priori sensiblement indépendante de la localisation du câble électrique 40 à l'intérieur de la boucle formée par le support 6 et indépendante de la présence d'autres câbles parcourus par des courants situés à l'extérieur de la boucle.

La gouttière 10 du support 6 permet de protéger le circuit électrique 4.

Les guides internes 22, 24 et externes 18, 20 facilitent le passage du câble électrique 40 dans l'ouverture 12 du support 6, de l'intérieur de la boucle vers l'extérieur de la boucle, et inversement.

L'élément de maintien en position 26 du support 6 garantit, grâce à son logement 46, que le câble électrique 40 occupe une position prédéterminée par rapport au support 6, donc par rapport au circuit électrique 4. Ainsi, si le circuit électrique 4 n'est pas un tore de Rogowski parfait (pour lequel la position n'a pas d'effet sur la mesure), la précision et la reproductibilité de la mesure sont améliorées.

L'élément de maintien en position 26 permet aussi de maintenir le capteur 1 sur le câble électrique 40, ce qui laisse les mains libres à l'opérateur pendant la mesure.

L'élément de maintien en position 26, ayant une forme de lyre telle que décrite ci-dessus, crée une force de rappel contribuant à ramener le support 6 dans la première position lorsque les deux extrémités 14, 16 sont écartées l'une de l'autre.

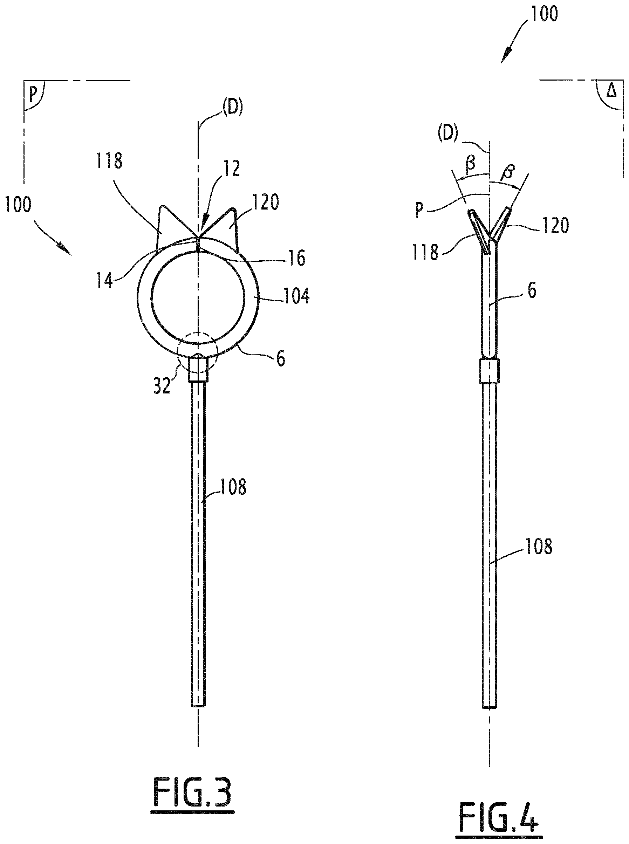

Sur les Figures 3 à 5, on a représenté un capteur non couvert par le texte des revendications.

On a représenté un capteur 100 en vue de face sur la Figure 3 et en vue de profil sur la Figure 4. Les mêmes références sont conservées pour les éléments structurellement identiques à ceux du premier mode de réalisation. Ceux-ci ne seront pas décrits en détail à nouveau.

Le capteur 100 diffère principalement en ce que le manche 108 est fixé non pas au niveau d'une extrémité du support, mais dans une région 32 sensiblement diamétralement opposée à l'ouverture 12 du support 6.

Le capteur 100 comprend deux guides externes 118, 120 qui sont chacun indépendants du manche 8, lequel est sensiblement rectiligne.

Selon un mode particulier de réalisation, les deux guides externes 118, 120 ne s'étendent pas dans le plan P de la boucle formée par le support 6, mais forment chacun un angle β donné avec ce plan, les deux guides externes 118, 120 se situant de part et d'autre du plan P.

Du fait de la position du manche 108, le circuit électrique 104 est adapté pour que les bornes d'entrée A et de sortie B se situent au niveau de la partie médiane 32 du support 6.

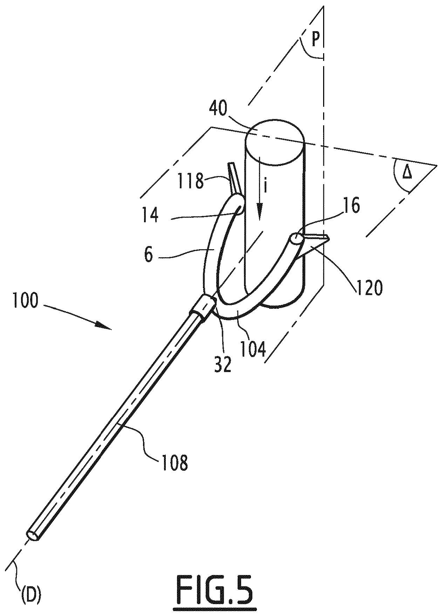

Pour faire entrer le câble électrique 40 dans la boucle formée par le support 6, on ne tire pas sur le manche 108 pour presser le support 6 contre le câble électrique 40 comme dans le premier mode de réalisation, mais on pousse sur le manche 108 pour exercer cette pression, comme illustré sur la Figure 5.

Lorsque le support 6 est pressé contre le câble électrique 40 pour faire entrer ce dernier à l'intérieur de la boucle formée par le support 6, le support 6 se déforme alors d'une manière particulière. En effet, les extrémités du support 14, 16 ne s'écartent alors pas l'une de l'autre dans le plan P, mais sensiblement orthogonalement au plan P. Ainsi la zone médiane 32 du support 6, pendant la déformation de la première position vers la seconde position, n'est pas sollicitée en flexion comme dans le premier mode de réalisation, mais en torsion.

Les Figures 7 et 8 représentent deux formes possibles pour le circuit électrique 104, 204 dans l'exemple illustré sur les Figures 3 à 5. Ces circuits 104, 204 sont également des tores de Rogowski. Les éléments identiques conservent les mêmes références et seuls seront décrits les éléments différents.

Sur la Figure 7, un premier bobinage hélicoïdal 156 part de la borne d'entrée A et suit une branche 28 du support 6 jusqu'à un point C1 situé à l'extrémité de la branche 28. Un second bobinage hélicoïdal 158 part de la borne d'entrée A et suit l'autre branche 30 du support 6 jusqu'à un point C2 situé à l'extrémité de la branche 30 en question. Un fil de jonction 160 relie les deux points C1, C2 en passant par l'intérieur des deux bobinages 156, 158. La borne de sortie B est située sur le fil de jonction 160 entre les deux bobinages 156, 158. Les spires des bobinages 156, 158 sont orientées pour que les forces électromotrices induites dans les deux bobinages 156, 158 s'ajoutent constructivement l'une à l'autre pour former une tension V entre les bornes A et B.

Sur la Figure 8, un premier bobinage hélicoïdal 256 part de la borne d'entrée A et suit une branche 28 du support 6 jusqu'à un point C1 situé à l'extrémité de la branche 28. Un second bobinage hélicoïdal 258 part de la borne de sortie B et suit l'autre branche 30 du support 6 jusqu'à un point C2 situé à l'extrémité de la branche 30 en question. Un fil 260 relie les deux points C1, C2 en passant par l'intérieur des deux bobinages 256, 258. Les spires des bobinages 256, 258 sont orientées pour que les forces électromotrices induites dans les deux bobinages 256, 258 s'ajoutent l'une à l'autre pour former une tension V entre les bornes A et B.

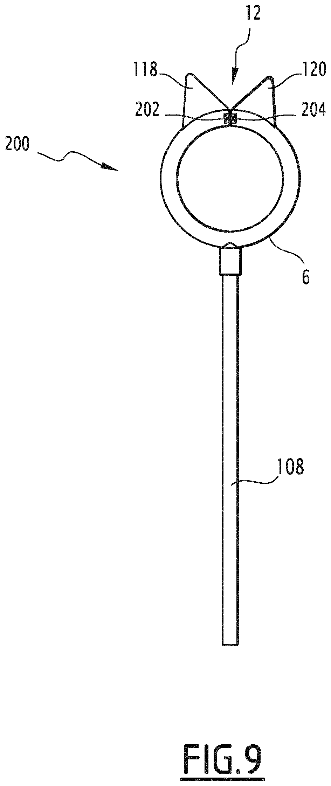

Sur la Figure 9, on a représenté un capteur 200 non couvert par le texte des revendications, qui est une variante du capteur 100 représenté sur les Figures 3 à 5. Les mêmes références sont reprises pour des éléments similaires, qui ne seront pas décrits à nouveau. Le capteur 200 diffère du capteur 100 par le fait qu'il comprend en outre deux aimants 202, 204 situés dans les extrémités 14, 16 du support 6.

Les aimants 202, 204 sont par exemple deux aimants permanents.

Les aimants 202, 204 sont placés de telle manière qu'ils s'attirent mutuellement lorsque le support 6 est dans la première position.

Les aimants 202, 204 exercent ainsi une action tendant à rapprocher l'une de l'autre les deux extrémités 14, 16, particulièrement lorsqu'elles ne sont pas trop éloignées l'une de l'autre, et à fermer la boucle formée par le support 6 dans la première position du support 6.

En variante, le circuit électrique 4 n'est pas défini dans une gouttière 10 ménagée dans le support 6, mais est fixé par d'autres moyens sur le support 6.

## Revendications

1. Capteur (1) pour la mesure d'un courant (i) dans un câble électrique (40), le capteur (1) comprenant un circuit électrique (4) et un support (6) du circuit électrique, le circuit électrique (4) étant destiné à entourer le câble électrique (40) pendant ladite mesure en formant une boucle, le support (6) présentant une ouverture (12) interrompant la boucle et le support (6) comprenant deux extrémités (14, 16) situées de part et d'autre de l'ouverture (12), le circuit électrique (4) comportant un bobinage hélicoïdal (56), le capteur (1) comprenant en outre un manche fixé au support pour presser l'ouverture (12) du support (6) contre le câble électrique, le support (6) étant déformable élastiquement entre :
- une première position dans laquelle il est au repos et les deux extrémités (14, 16) sont sensiblement en vis-à-vis, et
- une seconde position dans laquelle les deux extrémités (14, 16) sont écartées l'une de l'autre par rapport à la première position,
le support (6) étant suffisamment souple et étant conformé de manière à ce que :
- l'on puisse déformer le support (6) de la première position vers la deuxième position en pressant manuellement l'ouverture (12) du support (6) contre le câble électrique (40), de manière à faire passer le câble électrique (40) de l'extérieur de la boucle vers l'intérieur de la boucle, ou de l'intérieur de la boucle vers l'extérieur de la boucle, et
- le support (6) repasse spontanément de la seconde position à la première position, une fois le câble électrique (40) passé par l'ouverture (12),
le support (6) comprenant un premier guide externe (18) et un second guide externe (20) pour canaliser le câble électrique (40) vers l'ouverture (12) du support (6) et faciliter la déformation du support (6) depuis la première position vers la seconde position, lorsque le câble électrique (40) et l'ouverture (12) du support sont pressés l'un vers l'autre, le câble électrique (40) se situant à l'extérieur de la boucle, le manche (8) comprenant une partie principale (52) sensiblement rectiligne destinée à être tenue par un opérateur, le manche (8) comprenant en outre une partie terminale (54) solidaire du support (6) et faisant un angle obtus avec la partie principale (52), la partie terminale (54) formant le second guide externe (20),
le capteur (1) étant **caractérisé en ce qu'**il comprend un élément de maintien en position (26) du câble électrique (40), l'élément de maintien en position (26) étant situé à l'intérieur de la boucle formée par le support (6) et comprenant un logement (46) pour recevoir le câble électrique (40) dans une position prédéfinie par rapport au circuit électrique (4).

2. Capteur (1) selon la revendication 1, **caractérisé en ce que** l'élément de maintien en position (26) comprend deux parties tubulaires (48, 50) s'étendant sensiblement dans un plan (P) défini par le support (6), les parties tubulaires étant fixées chacune au support (6) par deux extrémités, les parties tubulaires (48, 50) ayant, prises ensemble, une forme de lyre dans ledit plan (P), la partie ventrue de la lyre constituant le logement (46) de l'élément de maintien en position (26).

3. Capteur (1) selon la revendication 2, **caractérisé en ce que** le support (6) comprend deux guides internes (22, 24) pour canaliser le câble électrique (40) vers l'ouverture (12) du support (6) et faciliter la déformation du support (6) depuis la première position vers la seconde position, lorsque le câble électrique (40) et l'ouverture du support sont pressés l'un vers l'autre, le câble électrique (40) se situant à l'intérieur de la boucle.

4. Capteur (1) selon la revendication 3, **caractérisé en ce que** les parties tubulaires (48, 50) sont fixées par l'une de leurs extrémités au support (6) au niveau d'une partie médiane (32) du support (6), la partie médiane (32) étant située à l'opposé de l'ouverture (12) du support (6) et par l'autre de leurs extrémités (14, 16) sur l'un des guides internes (22, 24), chaque partie tubulaire (48, 50) comprend, en vue de face perpendiculairement à ladite boucle, une section rectiligne située du côté de la partie médiane (32) du support et une section en S située du côté du guide interne (22, 24).

5. Capteur (1) selon l'une quelconque des revendications 1 à 4, **caractérisé en ce que** le premier guide externe (18) présente la forme d'une cale triangulaire en vue de face perpendiculairement à ladite boucle.

6. Capteur (1) selon l'une quelconque des revendications 1 à 5, **caractérisé en ce que** le circuit électrique (4) forme un tore de Rogowski comportant une ouverture, l'ouverture du tore se situant de part et d'autre de l'ouverture (12) du support (6).

7. Capteur (1) selon l'une quelconque des revendications 1 à 6, **caractérisé en ce que** le support (6) comprend un logement s'étendant le long de ladite boucle pour recevoir le bobinage hélicoïdal (56) du circuit électrique (4).

8. Procédé de mesure d'un courant (i) circulant dans un câble électrique (40), **caractérisé en ce qu'**il met en oeuvre un capteur (1) selon l'une quelconque des revendications précédentes et comprend les étapes suivantes :
- le câble électrique (40) se situant à l'extérieur de la boucle et le support (6) se trouvant dans la première position, on presse manuellement le support (6) contre le câble électrique (40), le câble électrique (40) étant en contact avec le support (6) de part et d'autre de l'ouverture (12) du support, de manière à déformer le support (6) de la première position vers la seconde position et à faire entrer le câble électrique (40) dans la boucle ; et
- le câble électrique (40) se situant à l'intérieur de la boucle et le support (6) ayant repris la première position, on mesure une ou plusieurs caractéristiques d'un courant (i) induit dans le circuit électrique (4, 104, 204) par le courant (i) circulant dans le câble électrique (40), et on déduit une valeur du courant circulant dans le câble électrique à partir de la ou des caractéristiques mesurées.

9. Procédé de mesure selon la revendication précédente, **caractérisé en ce qu'**il comprend en outre l'étape suivante : le câble électrique (40) se situant à l'intérieur de la boucle et le support (6) se trouvant dans la première position, on presse manuellement le support (6) contre le câble électrique, le câble électrique étant en contact avec le support (6) de part et d'autre de l'ouverture (12) du support, de manière à déformer le support (6) de la première position vers la seconde position et à faire sortir le câble électrique (40) de la boucle.

## Patentansprüche

1. Sensor (1) zum Messen eines Stroms (i) in einem elektrischen Kabel (40), wobei der Sensor (1) eine elektrische Schaltung (4) und einen Träger (6) für die elektrische Schaltung umfasst, wobei die elektrische Schaltung (4) dazu bestimmt ist, das elektrische Kabel (40) während des Messens in Form einer Schlaufe zu umgeben. Der Träger (6) weist eine Öffnung (12) auf, die die Schlaufe unterbricht, und der Träger (6) umfasst zwei Enden (14, 16), die auf beiden Seiten der Öffnung (12) angeordnet sind, wobei die elektrische Schaltung (4) eine Spiralwicklung (56) aufweist, wobei der Sensor (1) ferner einen Griff aufweist, der am Träger befestigt ist, um die Öffnung (12) des Trägers (6) gegen das elektrische Kabel zu drücken, wobei der Träger (6) elastisch verformbar ist zwischen:
- einer erste Position, in der er sich in Ruhe befindet und die beiden Enden (14, 16) im Wesentlichen einander gegenüberliegen, und
- einer zweite Position, in der die beiden Enden (14, 16) im Vergleich zur ersten Position voneinander beabstandet sind,
wobei der Träger (6) ausreichend flexibel ist und so geformt ist, dass:
- der Träger (6) von der ersten Position in die zweite Position verformt werden kann, indem die Öffnung (12) des Trägers (6) manuell gegen das elektrische Kabel (40) gedrückt wird, um das elektrische Kabel (40) von der Außenseite der Schlaufe in die Innenseite der Schlaufe oder von der Innenseite der Schlaufe in die Außenseite der Schlaufe zu führen, und
- der Träger (6) spontan von der zweiten Position in die erste Position zurückkehrt, nachdem das elektrische Kabel (40) durch die Öffnung (12) geführt wurde,
wobei der Träger (6) eine erste äußere Führung (18) und eine zweite äußere Führung (20) umfasst, um das elektrische Kabel (40) zur Öffnung (12) des Trägers (6) zu kanalisieren und das Verformen des Trägers (6) von der ersten Position in die zweite Position zu erleichtern, wenn das elektrische Kabel (40) und die Öffnung (12) des Trägers zusammengedrückt werden, wobei das elektrische Kabel (40) sich außerhalb der Schlaufe befindet. Der Griff (8) umfasst einen im Wesentlichen geraden Hauptteil (52), der dazu bestimmt ist, von einem Bediener gehalten zu werden, wobei der Griff (8) außerdem einen Endteil (54) umfasst, der fest mit dem Träger (6) verbunden ist und einen stumpfen Winkel mit dem Hauptteil (52) bildet, wobei der Endteil (54) die zweite äußere Führung (20) bildet,
wobei der Sensor (1) **dadurch gekennzeichnet ist, dass** er ein Positionshalteelement (26) für das elektrische Kabel (40) umfasst, wobei das Positionshalteelement (26) sich innerhalb der vom Träger (6) gebildeten Schlaufe befindet und eine Aufnahme (46) für das elektrische Kabel (40) in einer vorbestimmten Position in Bezug auf die elektrische Schaltung (4) umfasst.

2. Sensor (1) nach Anspruch 1, **dadurch gekennzeichnet, dass** das Positionshalteelement (26) zwei rohrförmige Teile (48, 50) umfasst, die sich im Wesentlichen in einer Ebene (P) erstrecken, die durch den Träger (6) definiert ist, wobei die rohrförmigen Teile jeweils mit zwei Enden an dem Träger (6) befestigt sind, wobei die rohrförmigen Teile (48, 50) zusammengenommen in der genannten Ebene (P) eine Leierform aufweisen, wobei der bauchige Teil der Leier die Aufnahme (46) des Positionshalteelements (26) bildet.

3. Sensor (1) nach Anspruch 2, **dadurch gekennzeichnet, dass** der Träger (6) zwei innere Führungen (22, 24) umfasst, um das elektrische Kabel (40) zur Öffnung (12) des Halters (6) zu kanalisieren und die Verformung des Halters (6) aus der ersten Position in die zweite Position zu erleichtern, wenn das elektrische Kabel (40) und die Öffnung des Halters gegeneinander gedrückt werden, wobei sich das elektrische Kabel (40) im Inneren der Schleife befindet.

4. Sensor (1) nach Anspruch 3, **dadurch gekennzeichnet, dass** die rohrförmigen Teile (48, 50) mit einem ihrer Enden an dem Träger (6) an einem Mittelteil (32) des Trägers (6) befestigt sind, wobei sich der Mittelteil (32) gegenüber der Öffnung (12) des Trägers (6) befindet, und mit dem anderen ihrer Enden (14, 16) auf einer der inneren Führungen (22, 24), wobei jedes rohrförmige Teil (48, 50) in der Vorderansicht senkrecht zu der Schlaufe
einen geraden Abschnitt umfasst, der sich auf der Seite des Mittelteils (32) des Trägers befindet und
einen S-förmigen Abschnitt, auf der Seite der inneren Führung (22, 24).

5. Sensor (1) nach einem der Ansprüche 1 bis 4, **dadurch gekennzeichnet, dass** die erste äußere Führung (18) in der Vorderansicht senkrecht zu der Schlaufe die Form eines dreieckigen Keils aufweist.

6. Sensor (1) nach einem der Ansprüche 1 bis 5, **dadurch gekennzeichnet, dass** die elektrische Schaltung (4) einen Rogowski-Torus mit einer Öffnung bildet, wobei sich die Öffnung des Torus auf beiden Seiten der Öffnung (12) des Trägers (6) befindet.

7. Sensor (1) nach einem der Ansprüche 1 bis 6, **dadurch gekennzeichnet, dass** der Träger (6) eine Aufnahme umfasst, die sich entlang der Schlaufe erstreckt, um die Spiralwicklung (56) der elektrischen Schaltung (4) aufzunehmen.

8. Verfahren zum Messen eines Stroms (i), der in einem elektrischen Kabel (40) fließt, **dadurch gekennzeichnet, dass** es einen Sensor (1) nach einem der vorhergehenden Ansprüche einsetzt und die folgenden Schritte umfasst:
- wobei sich das elektrische Kabel (40) außerhalb der Schlaufe und der Träger (6) in der ersten Position befindet, der Träger (6) manuell gegen das elektrische Kabel (40) gedrückt wird, wobei das elektrische Kabel (40) auf beiden Seiten der Öffnung (12) des Trägers mit dem Träger (6) in Kontakt ist, um den Träger (6) von der ersten Position in die zweite Position zu verformen und das elektrische Kabel (40) in die Schlaufe zu führen; und
- wobei sich das elektrische Kabel (40) im Inneren der Schlaufe befindet und der Träger (6) die erste Position eingenommen hat, eine oder mehrere Eigenschaften eines Stroms (i) gemessen werden, der in der elektrischen Schaltung (4, 104, 204) durch den durch das elektrische Kabel (40) fließenden Strom (i) induziert wird, und man leitet einen Wert des in dem elektrischen Kabel fließenden Stroms aus der oder den gemessenen Eigenschaften ab.

9. Messverfahren nach dem vorhergehenden Anspruch, **dadurch gekennzeichnet, dass** es außerdem den folgenden Schritt umfasst: das elektrische Kabel (40) befindet sich innerhalb der Schlaufe und der Träger (6) befindet sich in der ersten Position. Der Träger (6) wird von Hand gegen das elektrische Kabel gedrückt, wobei das elektrische Kabel auf beiden Seiten der Öffnung (12) der Halterung mit dem Träger (6) in Kontakt ist, so dass der Träger (6) von der ersten Position in die zweite Position verformt wird und das elektrische Kabel (40) aus der Schlaufe herausgezogen wird.

## Claims

1. A sensor (1) for measuring a current (i) in an electrical cable (40), the sensor (1) comprising an electrical circuit (4) and a support (6) for the electrical circuit, the electrical circuit (4) being designed to surround the electrical cable (40) during said measurement, forming a loop, the support (6) having an opening (12) interrupting the loop and the support (6) comprising two ends (14, 16) located on either side of the opening (12), the electrical circuit (4) comprising a helical winding (56), the sensor (1) further comprising a handle fixed to the support to press the opening (12) of the support (6) against the electric cable, the support (6) being elastically deformable between:
- a first position in which it is at rest and the two ends (14, 16) are substantially opposite each other, and
- a second position in which the two ends (14, 16) are spaced apart from each other relative to the first position,
the support (6) being sufficiently flexible and being shaped so that:
- the support (6) can be deformed from the first position to the second position by manually pressing the opening (12) of the support (6) against the electrical cable (40), so as to cause the electrical cable (40) to pass from the outside of the loop to the inside of the loop, or from the inside of the loop to the outside of the loop, and
- the support (6) returns spontaneously from the second position to the first position, once the electrical cable (40) has passed through the opening (12),
the support (6) comprising a first external guide (18) and a second external guide (20) for channelling the electrical cable (40) to the opening (12) of the holder (6) and facilitating the deformation of the support (6) from the first position to the second position, when the electrical cable (40) and the opening (12) of the support are pressed towards each other, the electrical cable (40) being located outside the loop, the handle (8) comprising a substantially straight main part (52) intended to be held by an operator, the handle (8) further comprising an end part (54) integral with the support (6) and forming an obtuse angle with the main part (52), the end part (54) forming the second external guide (20),
the sensor (1) being **characterised in that** it comprises a position-holding element (26) for the electrical cable (40), the position-holding element (26) being located inside the loop formed by the support (6) and comprising a housing (46) for receiving the electrical cable (40) in a predefined position relative to the electrical circuit (4).

2. A sensor (1) according to Claim 1, **characterised in that** the position-holding element (26) comprises two tubular parts (48, 50) extending substantially in a plane (P) defined by the support (6), the tubular parts each being fixed to the support (6) by two ends, the tubular parts (48, 50), taken together, having a lyre shape in the said plane (P), the ventral part of the lyre constituting the housing (46) of the position-holding element (26).

3. A sensor (1) according to claim 2, **characterised in that** the support (6) comprises two internal guides (22, 24) for channelling the electrical cable (40) towards the opening (12) of the support (6) and facilitating the deformation of the holder (6) from the first position to the second position, when the electrical cable (40) and the opening of the support are pressed together, with the electrical cable (40) inside the loop.

4. A sensor (1) according to Claim 3, **characterised in that** the tubular parts (48, 50) are fixed by one of their ends to the support (6) at the level of a middle part (32) of the support (6), the middle part (32) being situated opposite the opening (12) of the support (6) and by their other ends (14, 16)
on one of the internal guides (22, 24), each tubular part (48, 50) comprises, in a front view perpendicular to said loop, a rectilinear section located on the side of the
middle part (32) of the support and an S-shaped section on the inner guide side (22, 24).

5. A sensor (1) according to any one of claims 1 to 4, **characterised in that** the first external guide (18) has the shape of a triangular wedge when viewed from the front perpendicular to said loop.

6. A sensor (1) according to any one of claims 1 to 5, **characterised in that** the electrical circuit (4) forms a Rogowski toroid comprising an opening, the opening of the toroid being located on either side of the opening (12) of the support (6).

7. A sensor (1) according to any one of claims 1 to 6, **characterised in that** the support (6) comprises a housing extending along said loop for receiving the helical winding (56) of the electrical circuit (4).

8. A method of measuring a current (i) flowing in an electric cable (40), **characterised in that** it uses a sensor (1) according to any one of the preceding claims and comprises the following steps:
- the electrical cable (40) being outside the loop and the support (6) being in the first position, the support (6) is manually pressed against the electrical cable (40), the electrical cable (40) being in contact with the support (6) on either side of the opening (12) of the support, so as to deform the support (6) from the first position to the second position and allow the electrical cable (40) to enter the loop; and
- the electrical cable (40) being inside the loop and the support (6) having returned to the first position, one or more characteristics of a current (i) induced in the electrical circuit (4, 104, 204) by the current (i) flowing in the electrical cable (40) are measured, and a value of the current flowing in the electrical cable is deduced from the characteristic or characteristics measured.

9. A measurement method according to the preceding claim, **characterised in that** it further comprises the following step: when the electrical cable (40) is inside the loop and the support (6) is in the first position, the support (6) is pressed manually against the electrical cable, the electrical cable being in contact with the support (6) on either side of the opening (12) of the support, so as to deform the support (6) from the first position to the second position and cause the electrical cable (40) to come out of the loop.
